Europäisches Patentamt

European Patent Office

Office européen des brevets

(19)

(11) Numéro de publication: **0 010 998**
**B1**

(12) **FASCICULE DE BREVET EUROPEEN**

(45) Date de publication du fascicule de brevet: **02.09.81**

(51) Int. Cl.³: **G 03 B 41/00, G 01 B 11/27**

(21) Numéro de dépôt: **79400616.3**

(22) Date de dépôt: **05.09.79**

(54) Procédé d'alignement optique de motifs dans deux plans rapprochés et dispositif d'alignement mettant en oeuvre un tel procédé.

(30) Priorité: **19.09.78 FR 7826816**

(43) Date de publication de la demande:
**14.05.80 Bulletin 80/10**

(45) Mention de la délivrance du brevet:
**02.09.81 Bulletin 81/35**

(84) Etats Contractants Désignés:
**CH DE FR GB NL**

(73) Titulaire: **THOMSON-CSF**
**173, Boulevard Haussmann**
**F-75360 Paris Cedex 08 (FR)**

(72) Inventeur: **Fay, Bernard**
**"Thomson-CSF" - SCPI 173, bld Haussmann**
**F-75360 Paris Cedex 08 (FR)**
Inventeur: **Trotel, Jacques**
**"Thomson-CSF" - SCPI 173, bld Haussmann**
**F-75360 Paris Cedex 08 (FR)**
Inventeur: **Frichet, Alain**
**"THOMSON-CSF",-SCPI 173 bld Haussmann**
**F-75360 Paris Cedex 08 (FR)**

(74) Mandataire: **Lepercque, Jean et al,**
**"THOMSON-CSF" - SCPI 173, Bld. Haussmann**
**F-75360 Paris Cedex 08 (FR)**

(56) Documents cités:
**FR - A - 2 052 729**
**FR - A - 2 062 604**
**FR - A - 2 379 097**
**GB - A - 1 145 721**
**US - A - 3 690 881**
**US - A - 3 768 911**
**US - A - 3 783 520**

**APPLIED OPTICS, vol. 7, n° 6, juin 1972, pages 995—1005 New York, US**

**APPLIED OPTICS, vol. 11, n° 11, novembre 1972, pages 2455—2459 New York, US**
**M. C. KING et D. H. BERRY: "Photolithographic Mask alignment using moiré-techniques"**

**W. B. HERRMANSFELD: "Precision Alignment using a system of large rectangular Fresnel Lenses"**
**\*Pages 995—1005\***

**TNO-Nieuws, vol. 22, n° 4, avril 1967, Den Haag, NL**
**A. van MILAAN: "Een eenvoudige optische uitlijnmethode met een grote nauwkeurigheid", pages 162—164.**

Courier Press, Leamington Spa, England.

## Procédé d'alignement optique de motifs dans deux plans rapprochés et dispositif d'alignement mettant en oeuvre un tel procédé

L'invention se rapporte à la fabrication de circuits par microlithographie et a plus particulièrement pour objet un procédé d'alignement optique de masques et d'échantillons situés dans des plans rapprochés et le dispositif d'alignement mettant en oeuvre ce procédé.

Dans les dispositifs de reproduction de motifs sur un échantillon, par exposition à un rayonnement X ou à un rayonnement lumineux à travers un masque convenable situé à quelques micromètres de l'échantillon, chaque opération nécessite un alignement précis du masque et de l'échantillon. Pour obtenir cet alignement avec une précision de l'ordre du dizième de micromètre plusieurs procédés d'alignement utilisant les propriétés de diffraction de la lumière par des réseaux ont été décrits, par exemple la méthode des franges de Moiré, ou les méthodes de Torii et de Smith. Ces méthodes consistent à inscrire sur le masque et sur l'échantillon des réseaux de pas déterminés et à détecter le rayonnement diffracté par ces deux réseaux situés dans des plans rapprochés.

La méthode des franges de Moiré consiste, à inscrire sur le masque et sur l'échantillon deux réseaux de pas légèrement différents. La combinaison des différents ordres de diffraction donne un système de franges dont l'étalement est d'autant plus grand que la différence des pas des réseaux est faible. Le gain en précision espéré par cette amplification spatiale des franges est perdu en lumière cohérente par les problèmes de bruits (speckle, inferférences ...) et en lumière incohérente par le mauvais contraste des franges.

La méthode de Torii consiste à inscrire sur le masque et sur l'échantillon des réseaux complémentaires, chacun de ces réseaux ayant des zones absorbantes de largeur l et des zones transparentes de largeur 3×l. L'éclairement est réalisé en lumière monochromatique. Les deux réseaux sont intercalés lorsque l'alignement est réalisé. Une telle méthode permet de détecter, dans la position alignée, un extremum dans une direction déterminée, mais la position de cet extremun, dépend de l'espacement entre les plans à aligner.

Enfin, la méthode de Smith consiste à inscrire sur le masque et sur l'échantillon, deux réseaux de même pas, à éclairer par une onde plane monochromatique et à mesurer l'intensité diffractée par les deux réseaux dans des ordres de diffraction résultants symétriques (par exemple l'ordre résultant+1 et l'ordre résultant −1). L'alignement des deux réseaux est réalisé lorsque ces deux signaux sont égaux. L'inconvénient de cette méthode est une forte sensibilité à l'espacement des deux plans ainsi qu'à la symétrie des réseaux réalisés.

Toutes ces méthodes laissent subsister une indétermination dûe à la périodicité du signal résultant et il est alors nécessaire de lever l'incertitude par une autre méthode.

L'invention a pour but de fournir un procédé d'alignement de deux plans rapprochés et le dispositif d'alignement mettant en oeuvre ce procédé, permettant d'éviter les inconvénients des procédés sus-mentionnés et permettant en particulier d'obtenir un alignement avec une grande précision de deux plans rapprochés, et de tolérer sans perte de précision d'alignement des variations d'espacement des deux plans plus grandes que dans les procédés d'alignement antérieurement connus.

Pour cela, une lentille à zones de Fresnel linéaires est inscrite sur le masque et un trait, de largeur supérieure ou égale à la largeur de la plus petite zone de Fresnel inscrite sur le masque, est inscrit sur l'échantillon. L'éclairement du masque par faisceau de lumière monochromatique parallèle, laser par exemple, permet de former sur l'échantillon une tache d'éclairement rectangulaire (foyer) correspondant à l'ordre de diffraction+1 qui lorsqu'elle recouvre le trait repère formé sur l'échantillon conduit à détecter un maximum ou un minimum d'éclairement du rayonnement réfléchi par l'échantillon suivant que le repère inscrit sur cet échantillon est plus ou moins réfléchissant que la zone qui l'entoure.

L'invention sera mieux comprise et d'autres caractéristiques apparaîtront à l'aide de la description qui suit en référence aux figures annexées:

La figure 1 représente un exemple de dessins inscrits sur le masque et l'échantillon pour l'alignement;

Les figure 2 et 3 représentent des schémas explicatifs du fonctionnement du dispositif;

Les figures 4, 5, 6 représentent des exemples de dispositifs optiques utilisables pour isoler le rayonnement de retour réfléchi par l'échantillon du rayonnement ambiant;

La figure 7 représente un second exemple de dessins inscrits sur le masque et sur l'échantillon pour l'alignement;

La figure 8 est un schéma explicatif;

La figure 9 représente un schéma du dispositif d'alignement optique suivant l'invention.

Les figures 10a et 10b représentent, dans le plan de l'échantillon, des repères permettant d'obtenir un signal d'approche.

La figure 11 représente une vue, dans le plan du masque, d'un ensemble de repères permettant l'alignement complet de l'échantillon.

La figure 12 représente en coupe un repère échantillon formé par variation de relief.

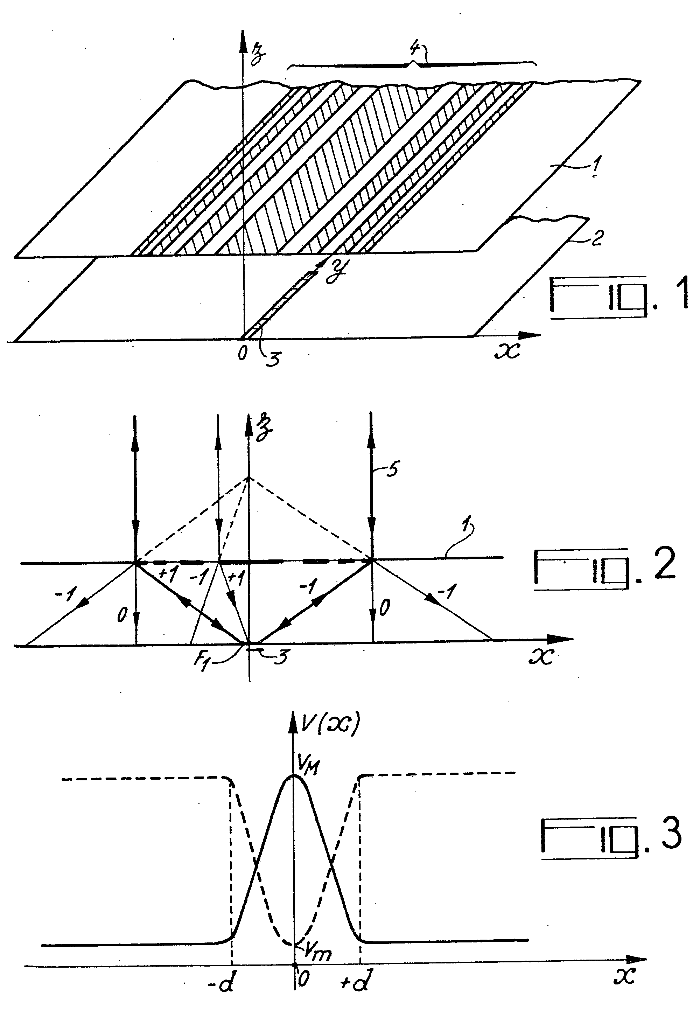

Sur la figure 1 ont été représentés schématiquement sur le masque 1, et l'échantillon 2 les dessins nécessaires à l'alignement. Sur le masque 1, a été inscrite une lentille 4 à zones de Fresnel linéaires, formée de bandes d'inégales largeurs, réparties suivant une distribution de Fresnel, alternativement opaques et transparentes.

La bande centrale a été représentée opaque, mais la disposition inverse est également possible. Sur un axe parallèle à la direction d'alignement Ox et perpendiculaire à la direction Oy des bandes, les transitions entre ces bandes ont respectivement pour abscisses $r_n$ tels que:

$$r_n^2 = n\,F\,\lambda + n^2\,\frac{\lambda^2}{4}$$

où n est le numéro de la bande, F est la longueur focale souhaitée pour la lentille et $\lambda$ est la longueur d'onde du rayonnement monochromatique éclairant cette lentille. La longueur focale F qui correspond au foyer principal d'ordre 1, $F_1$ de la lentille est choisie égale à la distance séparant les deux plans à aligner, le plan du masque et celui de l'échantillon. Cette distance est de l'ordre d'une dizaine de micromètres. Du fait de l'inégalité des surfaces des bandes, (les zones de Fresnel étant linéaires), la contribution des différentes zones au rayonnement diffracté diminue rapidement lorsque l'on s'éloigne de la bande centrale. Par conséquent une lentille formée d'un nombre assez restreint de bandes suffit pour obtenir un rendement correct. A l'extrême, la lentille peut être limitée à une seule zone: la zone centrale.

La figure 2 montre un schéma, dans le plan xoz, du rayonnement diffracté par une telle lentille éclairée par un faisceau parallèle 5. Cette lentille transmet sans la diffracter (ordre 0) une partie du rayonnement et diffracte une autre partie du rayonnement en formant pour une source à l'infini, des images réelles correspondant aux ordres +1, +2, etc... et des images virtuelles correspondant aux ordres −1, −2, etc... Sur la figure 2, les ordres 0, 1 et −1 ont été représentés. La tache d'éclairement formée sur l'échantillon, lorsque le plan de l'échantillon est à une distance du masque égale à la longueur focale principale (ordre +1) de la lentille, est une bande de largeur approximativement égale à la largeur des bandes extérieures de la lentille à zones de Fresnel. Lorsque le plan de l'échantillon est à une distance supérieure ou inférieure à la longueur focale, l'ordre 1 est encore concentré sur l'échantillon en une tache lumineuse un peu plus large et un peu moins concentrée, mais encore utilisable pour obtenir l'alignement.

Un trait 3 est inscrit sur l'échantillon 2; ce trait est soit plus réfléchissant soit moins réfléchissant que la zone qui l'entoure. Dans les deux cas, le rayonnement réfléchi par le substrat est utilisable pour obtenir l'alignement. Dans le premier cas, le rayonnement réfléchi détecté passe par un maximum lorsque l'ordre 1 diffracté par la lentille à zones de Fresnel linéaires et le trait sont alignés et dans le second cas, le rayonnement réfléchi détecté passe par un minimum.

Pour que l'alignement soit obtenu avec une bonne précision, il est nécessaire que la largeur d, de la tache d'éclairement soit sensiblement égale à la largeur w du trait repère inscrit sur l'échantillon de sorte qu'il existe une position dans laquelle tout le rayonnement concentré dans l'ordre 1 du faisceau diffracté soit réfléchi ou absorbé, et que l'on obtienne un extremum assez contrasté par rapport au rayonnement réfléchi en permanence par l'échantillon.

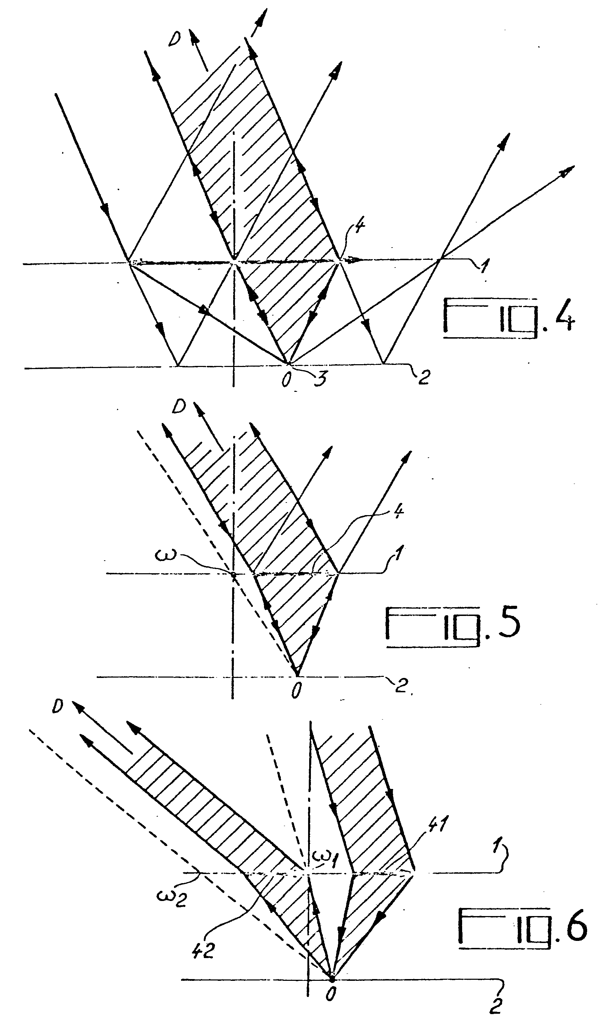

La figure 3 représente un exemple de signal détecté V(x) pour w=d, en trait plein lorsque le repère est réflecteur et en traits pointillés lorsque le repère est absorbant, la lentille étant déplacée par rapport au trait repère suivant l'axe Ox, l'extremum est $V_M$ ou $V_m$ selon que le repère est réfléchissant ou absorbant.

Lorsque le distance entre le plan de l'échantillon et le plan du masque varie autour de la longueur focale principale de la lentille, le contraste diminue, mais cette distance n'est pas critique et le réglage peut encore être obtenu. De plus, il est possible d'utiliser les variations du maximum de signal pour effectuer un réglage fin de cette distance à une valeur prédéterminée.

Le rayonnement réfléchi par l'échantillon repasse à travers la lentille à zones de Fresnel et peut être détecté, après séparation par rapport au rayonnement incident effectué par exemple par une lame séparatrice. Mais un tel système conduit à une interaction entre le rayonnement utile et le rayonnement diffracté par le masque.

Pour obtenir une séparation spatiale du rayonnement réfléchi ou diffracté par le masque et du rayonnement de retour émergeant du masque après réflexion sur l'échantillon, plusieurs dispositifs peuvent être utilisés. Ces dispositifs sont d'autant plus performants qu'ils minimisent le fond continu détecté et qu'ils conservent la symétrie du système de manière à réduire l'influence de certains paramètres, comme par exemple l'espacement.

Les figures 4, 5 et 6 illustrent schématiquement trois dispositifs possibles pour éviter l'intéraction du rayonnement à détecter et du rayonnement réfléchi ou diffracté par le masque.

La figure 4 montre une solution dans laquelle le rayonnement parallèle 5 incident sur la lentille à zones de Fresnel linéaires 4 a une incidence oblique sur cette lentille. La lentille à zones de Fresnel a été représentée sous la forme conventionnelle des lentilles convergentes dans le plan du masque 1. Le rayonnement transmis sans diffraction (ordre 0) par le masque et le rayonnement réfléchi par le masque émergent dans une direction oblique par rapport à la normale au masque. Le faisceau convergent (ordre 1) diffracté par le masque est réfléchi par le trait (dans le cas où ce trait est plus réflecteur que la zone qui l'entoure) et émerge du masque. Seule la partie du rayonnement émergeant du masque après avoir retraversé la lentille 4 est détectée dans la direction D dans une zone non brouillée par le fond continu. De plus le rayonnement détecté n'interagit pas avec le rayonnement réfléchi ou diffracté par le masque.

La figure 5 représente un autre dispositif optique susceptible d'être utilisé pour mesurer l'intensité du rayonnement réfléchi ou diffracté par le trait. Dans ce dispositif la lentille à zones de Fresnel linéaires est seulement utilisée partiellement, son centre $\omega$ étant situé hors du faisceau incident oblique sur cette lentille. Cette disposition est semblable à celle de la figure 4 pour ce qui est des effets et revient à employer un faisceau incident de section égale à la section utile du faisceau de la figure 4 (hachurée sur cette figure), mais dans ce dispositif le réglage de l'espacement doit être très précis pour que le rayonnement de retour traverse la lentille.

La figure 6 représente un autre dispositif optique dans lequel deux demi lentilles coplanaires de même distance focale, décentrées par rapport à l'axe optique du rayonnement incident, sont utilisées pour séparer spatialement les différents faisceaux réfléchis ou diffractés. Ces deux demi lentilles 41 et 42, de centres respectifs $\omega_1$ et $\omega_2$ sont utilisées l'une pour focaliser le faisceau incident sur l'échantillon, l'autre pour collimater le faisceau réfléchi par le trait et détecté dans la direction D.

Les dispositifs décrits en référence aux figures 4, 5 et 6 permettent d'éviter l'interaction entre le rayonnement réfléchi ou diffracté par le masque et le rayonnement à détecter réfléchi par le trait et collmaté par la lentille, et permettent également de minimiser le fond continu dans la direction de détection mais, du fait de l'incidence oblique du rayonnement incident sur la lentille, pour obtenir un signal maximum la distance entre les deux plans doit être préalablement bien réglée de telle manière que la rayonnement réfléchi soit bien transmis en direction du dispositif de détection.

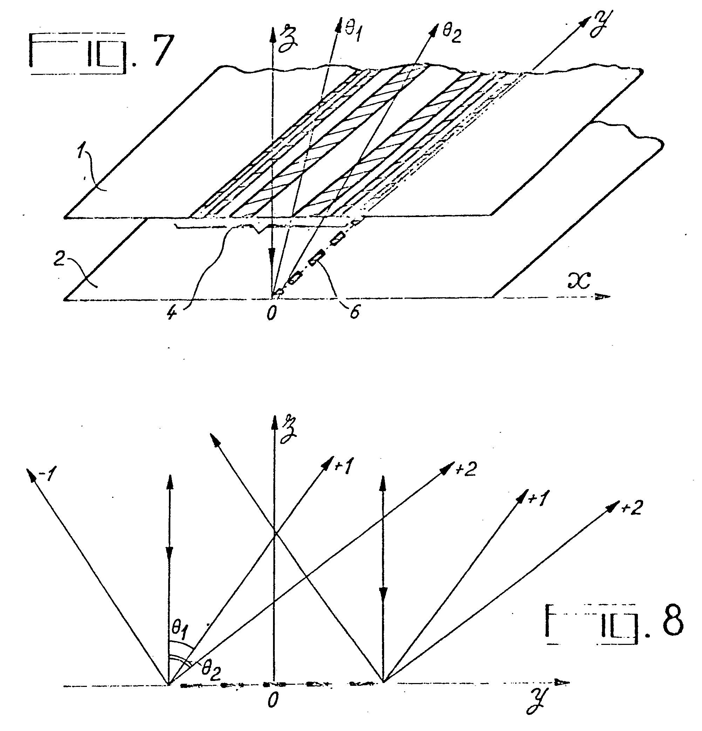

Pour s'affranchir de cette contrainte, un autre dispositif permettant de séparer le rayonnement réfléchi ou diffracté par le masque et le rayonnement de retour utile émergeant du masque peut être utilisé. Ce dispositif, utilisant les propriétés de diffraction des réseaux de pas constants, est représenté sur la figure 7. Le trait continu 3 inscrit sur l'échantillon représenté sur la figure 1, est remplacé sur la figure 7 par un trait discontinu 6 dans la direction Oy formant un réseau de pas p. Le dispositif fonctionne alors de la manière suivante: le rayonnement parallèle est incident normalement (ou obliquement) sur le masque 1 et forme sur l'echantillon 2 une tache lumineuse rectangulaire allongée dans la direction Oy correspondant à la direction du trait. Le rayonnement ainsi reçu par le trait est réfléchi suivant l'ordre 0 du réseau formé par le trait et diffracté suivant des directions du plan yoz formant avec l'axe Oz des angles On tels que si

$$n\theta \ n = n \ \frac{\lambda}{p} \, ,$$

n étant l'ordre de diffraction et $\theta n$ l'angle de déviation correspondant. Dans chacune de ces directions de diffraction, des moyens de détection permettent de détecter un maximum lorsque la tache lumineuse et le trait interrompu sont alignés; ces directions étant obliques par rapport au faisceau incident, le rayonnement de retour n'interagit pas avec le rayonnement réfléchi par le masque.

La figure 8 représente le rayonnement diffracté par le trait interrompu dans le plan yoz.

L'ordre +1, diffracté dans le plan yoz est incident obliquement sur la lentille à zones de Fresnel. La source de lumière diffracté étant dans le plan focal de la lentille, le rayonnement émerge de la lentille en un faisceau parallèle oblique par rapport à l'axe de la lentille.

Dans le mode de réalisation représenté sur la figure 7, le trait interrompu formant un réseau de pas constant est réalisé sous formes de zones ayant des coefficients de réflexion différents, obtenues par dépôt à travers un masque d'un composé plus (ou moins) réfléchissant que l'échantillon lui-même.

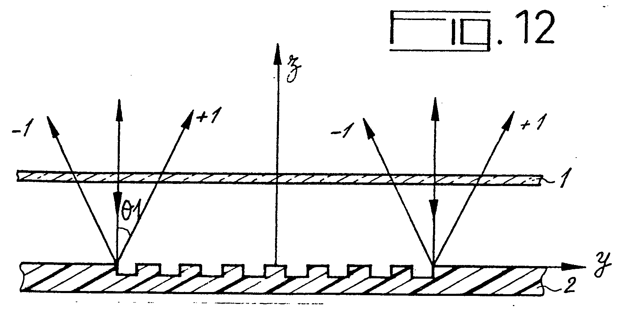

Un réseau réflecteur permettant de devier le faisceau de retour peut également être réalisé en formant par variation de relief périodique, de profondeur calculée, le long d'une ligne s'étendant dans la direction Oy, un réseau de phase réflecteur. La figure 12 représente un tel repère sur une coupe suivant Oy de l'échantillon 2. Un tel repère en relief peut être obtenu par gravure directe du substrat semi-conducteur (par action chimique ionique ou par plasma). Ou tel repère peut être plus résistant qu'un dépôt de faible épaisseur effectué sur une surface plane de l'échantillon et peut également être plus facile à préserver; ce qui permet, dans certains cas de disposer d'un repère échantillon permanent créé au cours de la première opération de masquage, ce repère étant ensuite utilisé pour l'alignement pour tous les niveaux de masquage suivants.

Le procédé d'alignement optique au moyen d'un dessin formant une lentille à zones de Fresnel sur le masque et d'un trait sur l'échantillon se prête aisément à l'alignement automatique. Pour cela, il faut créer un balayage alternatif de la tache rectangulaire d'éclairement sur l'échantillon, soit en déplaçant l'échantillon par rapport à cette tache, soit en déplaçant la tache lumineuse sur l'échantillon, le masque étant supposé fixe.

Le déplacement alternatif de l'échantillon, suivant l'axe d'alignement Ox, peut être obtenu au moyen d'un transducteur piézoélectrique, commandé par un signal alternatif, agissant dans la direction Ox. Le rayonnement de retour est alors détecté par un photomultiplicateur fournissant un signal de sortie d'amplitude variable appliqué à une entrée d'un détecteur synchrone recevant par ailleurs un signal synchrone du signal de commande appliqué au transducteur piézoélectrique. Le détecteur fournit un signal d'erreur qui peut être superposé au signal alternatif de commande appliqué au transducteur piézoélectrique pour déplacer le centre de balayage ou être appliqué à un dispositif de déplacement suivant Ox du plan du masque. L'amplitude du balayage est progressivement réduite à zéro lorsque le centrage est effectué.

Le déplacement alternatif de la tache lumineuse dans le plan de l'échantillon peut être obtenu, par exemple, par un miroir vibrant placé sur le trajet du rayonnement de manière à modifier l'angle d'incidence du faisceau parallèle sur le masque dans le plan xoz, tout en restant dans les limites qui conservent les les propriétés focalisatrices de la lentille de Fresnel. Ainsi, le faisceau, émergeant de la lentille formée sur le masque, converge sur l'échantillon suivant une tache lumineuse balayant un segment de l'axe Ox.

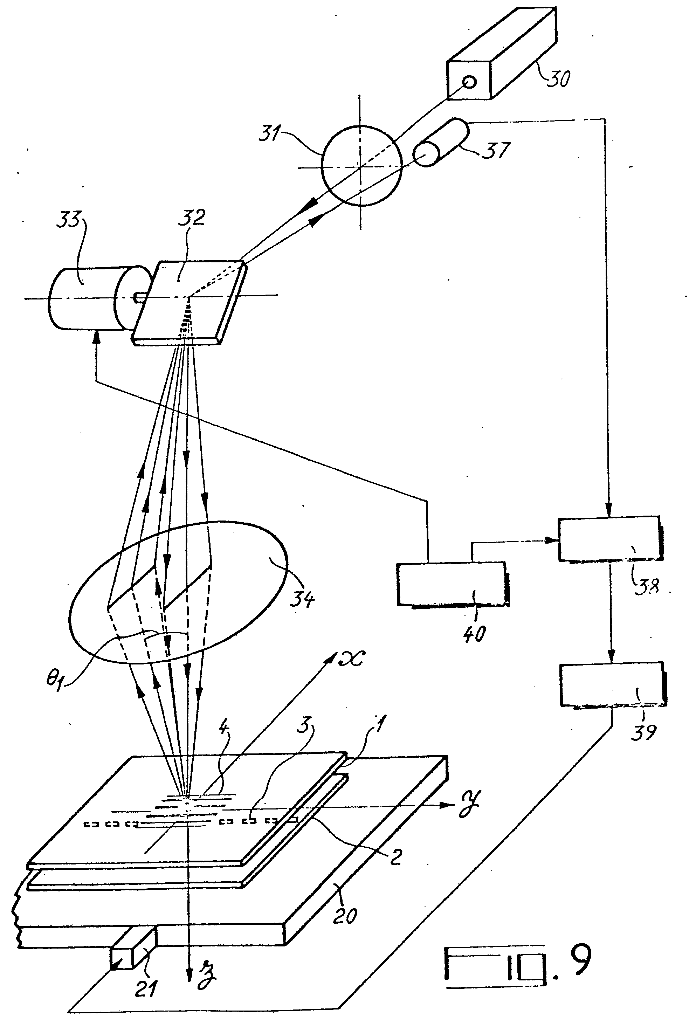

La figure 9 représente un schéma d'ensemble d'un dispositif automatique dans lequel le trait inscrit sur l'échantillon est interrompu périodiquement, pour renvoyer le rayonnement de retour suivant une direction différente, dans le plan yoz de la direction d'incidence, comme expliqué en référence à la figure 7 et dans lequel un miroir vibrant fait varier l'angle d'incidence du faisceau parallèle sur la lentille à zones de Fresnel. Le dispositif comporte une table 20 sur laquelle est placé l'échantillon 2. La table est susceptible d'être déplacée suivant Ox, suivant Oy et en rotation. Sur la figure, seul le transducteur piézoélectrique 21, commandant le déplacement suivant Ox a été représenté. Le masque 1 est placé, dans un porte masque non représenté, dans un plan parallèle au plan de la table et donc de l'échantillon, et à une distance de l'ordre de 10 $\mu$m.

Un trait interrompu 3 a été préalablement inscrit sur l'échantillon et une lentille à zones de Fresnel linéaires 4 a été préalablement inscrite sur le masque 1.

Le dispositif comporte en outre une source lumineuse 30 émettant en fonctionnement, un faisceau de lumière monochromatique parallèle en direction d'une lentille condenseur 31. Le faisceau émergeant de cette lentille est un faisceau convergent dont seulement l'axe optique a été représenté. Un miroir vibrant 32, commandé par un moteur 33 alimenté par un générateur 40, est placé de telle manière que l'axe de pivotement du miroir coupe l'axe optique de faisceau incident. Le faisceau est réfléchi par le miroir 32 vers une lentille 34, le faisceau issu de cette lentille 34 est un faisceau parallèle ayant une incidence variable sur le masque mais éclairant toujours sensiblement la même zone du masque, c'est-à-dire la zone où est inscrite la lentille à zones de Fresnel servant de repère. Pour cela, la zone d'impact du rayonnement sur le miroir 32 est conjuguée avec la zone repère sur le masque par rapport à la lentille 34. De plus, pour que le faisceau émergeant de cette lentille soit parallèle, la lentille 31 et la lentille 34 forment un système afocal. L'axe optique du faisceau issu du miroir 32 a été représenté pour les deux positions extrêmes et pour la position centrale de pivotement du miroir. La lentille de Fresnel focalise le rayonnement et forme sur l'échantillon un trait lumineux oscillant de part et d'autre d'une position centrale sur l'axe Ox. Du fait que le repère inscrit sur l'échantillon est un trait interrompu, le rayonnement réfléchi par l'échantillon est dévié dans le plan yoz de l'angle $O_1$ précédemment défini pour l'ordre 1 de diffraction. L'axe optique du rayonnement diffracté a été représenté pour les trois directions d'incidence précédentes. Ce rayonnement émerge de la lentille en un faisceau parallèle, passe à travers la lentille, est réfléchi par le miroir 32 et passe à travers la lentille 31. La zone d'impact du rayonnement de retour sur la lentille 34 étant différente de la zone d'impact du rayonnement incident, il en est de même sur la lentille 31. Par conséquent, le rayonnement de retour émergeant de cette lentille a un axe optique différent de celui du rayonnement incident: les deux faisceaux sont donc séparés spatialement. Le faisceau de retour est capté par un photomultiplicateur 37 qui délivre un signal d'amplitude variable avec la position relative du masque et de l'échantillon et avec la position du miroir vibrant 32. Le signal obtenu est appliqué, avec le signal alternatif de commande appliqué au moteur 33, (ou une harmonique impaire de ce signal), à un détecteur synchrone 38 fournissant un signal d'erreur qui a la propriété d'être nul lorsque la position alignée est atteinte. Ce signal d'erreur est alors appliqué à la source d'alimentation 39 du transducteur piézoélectrique 21 pour appliquer à l'échantillon un déplacement suivant Ox tel que le signal d'erreur soit progressivement ramené à zéro. Cette modulation de l'angle d'incidence du faisceau sur le masque peut être maintenue durant toute la durée de l'exposition de manière à rattraper les déplacements intempestifs de l'échantillon par rapport au masque.

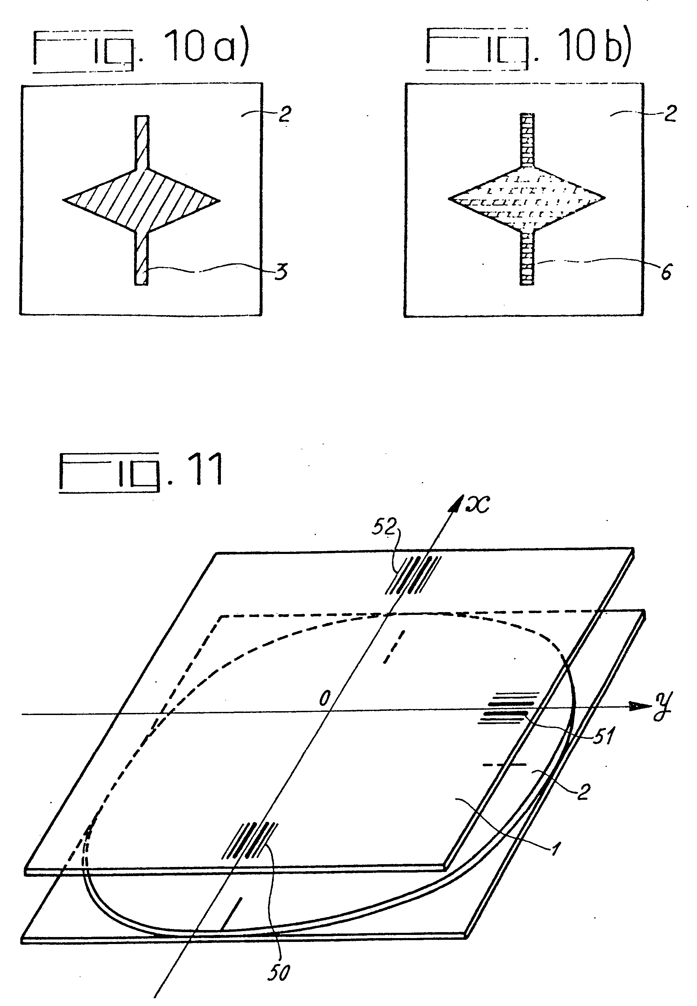

La largeur du trait étant faible, lorsque la tache lumineuse projetée de largeur sensiblement égale à celle du trait repère est complètement en dehors du trait repère, le niveau du signal d'erreur est constant et ne permet pas de donner une information sur le sens du déplacement à effectuer. Pour obtenir une information concernant l'approche, il est possible d'inscrire sur l'échantillon un trait repère auquel on ajoute dans la direction Ox des zones ayant le même coefficient de réflexion que le trait de façon à amorcer un changement de niveau de signal détecté lorsque la zone lumineuse approche du trait. Le motif repère peut avoir, par exemple la forme représentée sur la figure 10. La figure 10a) correspond au trait continu de la figure 1 auquel ont été ajoutées des zones réfléchissantes pour l'approche et la figure 10b) correspond au trait discontinu de la figure 7 auquel ont été ajoutées également des zones réfléchissantes latérales permettant l'approche.

La figure 9 qui montre l'ensemble du système a été limitée à un déplacement suivant Ox. Pour obtenir un alignement complet, il est possible d'inscrire sur l'échantillon deux autres lentilles à zones de Fresnel dont les traits sont parallèles à Ox et un trait correspondant sur l'échantillon parallèle à Ox de manière à effectuer l'alignement suivant la direction Oy et l'alignement en rotation.

La figure 11 montre un ensemble de repères permettant l'alignement complet de l'échantillon.

Dans ce plan, il y a trois zones de repères 50, 51 et 52 dans lesquelles ont été inscrites des lentilles à zones de Fresnel.

Dans les zones 50 et 52 les bandes sont parallèles à Ox et dans la zone 51 les bandes sont parallèles à Oy. Cette disposition, dans laquelle les bandes des zones de Fresnel et les traits correspondants sur l'échantillon sont disposés suivant des directions sensiblement radiales, est particulièrement intéressante lorsque l'échantillon est exposé à travers le masque à un rayonnement X car ce rayonnement est légèrement divergent et le motif est légèrement déformé radialement, le positionnement n'étant pas affecté.

Ces trois zones repères permettent un alignement de l'échantillon en x, en y et en rotation.

L'invention n'est pas limitée au procédé d'alignement et aux modes de réalisation du dispositif d'alignement précisément décrits. En particulier, pour augmenter le niveau des signaux détectés, il est possible d'inscrire dans une zone du masque d'une centaine de $\mu$m, plusieurs lentilles à zones de Fresnel linéaires parallèles et d'inscrire sur l'échantillon les traits repère correspondants. Ainsi le rayonnement détecté sera plus important. Le lentille à zones de Fresnel, peut également être limitée à un seul trait représentant la zone centrale, la réalisation de la lentille en est facilitée mais la précision obtenue est légèrement moins bonne. De plus, la lentille représentée sur la figure 1 a été représentée comme ayant une zone centrale opaque et la lentille représentée sur la figure 7 comme ayant une zone centrale transparente. En pratique, la seconde disposition peut être préférable dans le but d'augmenter le rapport signal sur bruit.

Le procédé d'alignement suivant l'invention permet d'obtenir un alignement masque-échantillon avec une précision meilleure que 0,1 $\mu$m.

## Revendications

1. Procédé d'alignement optique de motifs dans deux plans rapprochés utilisant des motifs repères inscrits sur les deux plans à aligner, caractérisé en ce qu'il utilise un motif repère inscrit sur le premier plan et formé d'au moins une lentille à zones de Fresnel linéaires alternativement opaques et transparentes perpendiculaires à l'axe d'alignement dans le plan, et un motif repère réfléchissant inscrit sur le second plan et comportant une zone centrale perpendiculaire à l'axe d'alignement, le procédé d'alignement consistant à éclairer, par un faisceau lumineux monochromatique parallèle, la lentille à zones de Fresnel linéaires de manière à former dans le second plan un trait lumineux ayant sensiblement les mêmes dimensions que la zone centrale du motif inscrit sur ce plan, à détecter le rayonnement réfléchi par ce second plan et émergeant de la lentille à zones de Fresnel linéaires, et à déplacer les deux plans l'un par rapport à l'autre jusqu'à ce que le rayonnement détecté passe par un extremum correspondant à l'alignement des deux repères.

2. Procédé d'alignement selon la revendication 1, caractérisé en ce que le motif repère inscrit sur le second plan comporte une zone centrale ayant un coefficient de réflexion différent de la zone qui l'entoure.

3. Procédé d'alignement selon la revendication 1, caractérisé en ce que la zone centrale du motif repère inscrit sur le second plan est formée d'éléments ayant des coefficients de réflexion différents s'étendant dans la direction perpendiculaire à la direction d'alignement pour former un réseau d'amplitude réflecteur de pas constant dans cette direction.

4. Procédé d'alignement selon la revendication 1, caractérisé en ce que la zone centrale du motif repère inscrit sur le second plan est gravée pour former un réseau de phase réflecteur de pas constant s'étendant dans la direction perpendiculaire à la direction d'alignement.

5. Procédé d'alignement selon l'une des revendications 1 à 4, caractérisé en ce que, pour un alignement automatique, l'angle d'incidence du faisceau sur la lentille à zones de Fresnel linéaires est dévié alternativement de part et d'autre d'une position moyenne, l'alignement automatique étant obtenu en commandant le déplacement relatif des deux plans par le signal de sortie d'un démodulateur synchrone recevant un signal caractéristique du rayonnement de retour réfléchi par le second plan et un signal synchrone du signal de commande de déviation du faisceau incident sur cette lentille.

6. Procédé d'alignement selon l'une quelconque des revendications 1 à 5, caractérisé en ce que le motif repère inscrit sur le second plan comporte, en plus de la zone centrale, des zones latérales allongées dans la direction d'alignement permettant d'effectuer une approche de la zone centrale avant l'alignement précis.

7. Procédé d'alignement selon l'une quelconque des revendications précédentes, caractérisé en ce que le motif repère inscrit sur le premier plan comporte plusieurs lentilles à zones de Fresnel linéaires parallèles, le motif correspondant inscrit sur le second plan comportant plusieurs zones centrales respectivement associées à ces lentilles.

8. Dispositif pour la mise en oeuvre du procédé selon la revendication 1 caractérisé en ce qu'il comporte une source de lumière monochromatique (30), un dispositif optique de projection (31, 32, 34) du rayonnement en un faisceau parallèle sur un masque, un motif repère (4) formant au moins une lentille à zones de Fresnel linéaires étant inscrit sous forme de zones opaques et transparentes sur le masque et une zone centrale réfléchissante parallèle aux zones de la lentille étant inscrite sur l'échantillon (2) à aligner avec le masque (1), des moyens de déplacement (21) de l'échantillon par rapport au masque suivant un axe orthogonal à la zone centrale inscrite étant prévus pour amener en coïncidence le trait lumineux formé par le faisceau d'ordre 1 diffracté par la lentille à zones de Fresnel linéaires et la zone centrale du motif inscrit sur l'échantillon, le dispositif comportant en outre un détecteur (37) détectant le rayonnement réfléchi par l'échantillon, la coïncidence correspondant à un extremum de signal.

9. Dispositif d'alignement selon la revendication 8, caractérisé en ce que la zone centrale du motif inscrit sur le masque forme un réseau réflecteur de pas constant, le rayonnement reçu par ce réseau étant diffracté dans le plan formé par l'axe optique du faisceau incident et le réseau, le détecteur étant situé dans l'axe du faisceau correspondant à l'un des ordres de diffraction, oblique par rapport à l'axe du rayonnement incident.

10. Dispositif d'alignement selon la revendication 9, caractérisé en ce que le détecteur est placé suivant l'axe optique du faisceau d'ordre 1 diffracté par le réseau réflecteur de pas constant.

11. Dispositif d'alignement selon l'une quelconque des revendications 8 à 10, caractérisé en ce qu'il comporte un dispositif de déviation du faisceau incident sur le masque commandé par un signal de commande de déviation, le dispositif optique de projection étant un dispositif afocal tel que la faisceau parallèle éclaire le masque dans la zone de la lentille avec une incidence variable, le trait lumineux projeté balayant l'échantillon, le détecteur fournissant alors un signal d'amplitude variable appliqué à un démodulateur synchrone auquel est appliqué un signal synchrone du signal de commande déviation, la sortie du démodulateur fournissant un signal d'erreur utilisé pour commander le déplacement relatif du masque et de l'échantillon.

12. Dispositif d'alignement selon l'une quelconque des revendications 8 à 11, caractérisé en ce que le motif repère inscrit sur le masque est formé de plusieurs lentilles à zones de Fresnel linéaires parallèles, le motif inscrit sur l'échantillon pour l'alignement comportant des zones centrales parallèles associées à ces lentilles.

13. Dispositif d'alignement selon l'une quelconque des revendications 8 à 12, caractérisé en ce qu'il comporte des moyens de déplacement de l'échantillon par rapport au masque suivant deux axes orthogonaux et en rotation, le masque comportant trois motifs repères, deux des motifs repère comportant chacun au moins une lentille à zones de Fresnel linéaires orthogonales à l'un des axes d'alignement et le troisième motif repère comportant au moins une lentille à zones de Fresnel linéaires orthogonales à l'autre axe d'alignement, les motifs repères associés aux lentilles étant inscrits sur l'échantillon, le dispositif optique de projection projetant le rayonnement sur chacun des repères suivant une procédure déterminée, un détecteur du rayonnement émergeant du masque après réflexion sur l'échantillon étant prévu pour chaque direction d'alignement.

## Patentansprüche

1. Verfahren zum optischen Ausrichten von Motiven in zwei aneinander angenäherten Ebenen unter Verwendung von Markierungsmotiven, die auf die zwei auszurichtenden Ebenen aufgezeichnet sind, dadurch gekennzeichnet, daß ein Markierungsmotiv verwendet wird, das auf die erste Ebene aufgezeichnet ist und aus wenigstens einer Fresnel-Zonenlinse gebildet ist, deren linienformige Zonen abwechselnd lichtundurchlässig und lichtdurchlässig sind und senkrecht zur Ausrichtachse in der Ebene verlaufen und ein reflektierendes Markierungsmotiv verwendet wird, das auf die zweite Ebene aufgezeichnet ist und eine mittlere Zone aufweist, die senkrecht zu der Ausrichtachse ist, wobei das Ausrichtverfahren darin besteht, daß die Fresnel-Zonenlinsen aus Linearzonen durch ein monochromatisches paralleles Lichtbündel so beleuchtet wird, daß in der zweiten Ebene ein Lichtstreifen gebildet wird, der im wesentlichen dieselben Abmessungen hat wie die mittlere Zone des auf diese Ebene aufgezeichneten Motivs, daß die von dieser zweiten Ebene reflektierte und aus der Fresnelzonenlinse mit linienförmigen Zonen austretende Strahlung erfaßt wird und daß die beiden Ebenen in bezug aufeinander verschoben werden, bis die erfaßte Strahlung durch einen Extremwert geht, welcher der Ausrichtung der beiden Markierungen entspricht.

2. Ausrichtverfahren nach Anspruch 1, dadurch gekennzeichnet, daß das auf die zweite Ebene aufgezeichnete Markierungsmotiv eine mittlere Zone umfaßt, die einen Reflexionskoeffizienten aufweist, der verschieden von der diese umgebenden Zone ist.

3. Ausrichtverfahren nach Anspruch 1, dadurch gekennzeichnet, daß die mittlere Zone des auf die zweite Ebene aufgezeichneten Markierungsmotivs aus Elementen gebildet ist, die verschiedene Reflexionskoeffizienten aufweisen und sich senkrecht zur Ausrichtrichtung erstrecken, um ein Reflexions-Amplitudengitter konstanter Teilung in dieser Richtung zu bilden.

4. Ausrichtverfahren nach Anspruch 1, dadurch gekennzeichnet, daß die mittlere Zone des Markierungsmotivs, das auf die zweite Ebene aufgezeichnet ist, eingraviert ist, um ein Reflexions-Phasengitter konstanter Teilung zu bilden, das sich senkrecht zur Ausrichtrichtung erstreckt.

5. Ausrichtverfahren nach einem der Ansprüche 1 bis 4, dadurch gekennzeichnet, daß zur automatischen Ausrichtung der Einfallswinkel des Bündels auf die Fresnelzonenlinse mit linienförmigen Zonen abwechselnd auf beiden Seiten einer mittleren Stellung abgelenkt wird, wobei die automatische Ausrichtung dadurch erhalten wird, daß die Relativverschiebung der beiden Ebenen durch das Ausgangssignal eines Synchron-demodulators gesteuert wird, der ein für die von der zweiten Ebene reflektierte Rückstrahlung charakteristisches Signal und ein Signal empfängt, das synchron mit dem Steuersignal zur Ablenkung des auf diese Linse auftreffenden Bündels ist.

6. Ausrichtverfahren nach einem der Ansprüche 1 bis 5, dadurch gekennzeichnet, daß das auf die zweite Ebene aufgezeichnete Markierungsmotiv zusätzlich zu der mittleren Zone Seitenzonen umfaßt, die sich in der Ausrichtung erstrecken und vor der präzisen Ausrichtung eine Annäherung der mittleren Zone ermöglichen.

7. Ausrichtverfahren nach einem der vorstehenden Ansprüche, dadurch gekennzeichnet, daß das auf die erste Ebene aufgezeichnete Markierungsmotiv mehrere Fresnelzonenlinsen mit linienförmigen parallelen Zonen aufweist, wobei das auf die zweite Ebene aufgezeichnete entsprechende Motiv mehrere mittlere Zonen umfaßt, die jeweils diesen Linsen zugeordnet sind.

8. Vorrichtung zur Durchführung des Verfahrens nach Anspruch 1, dadurch gekennzeichnet, daß sie eine monochromatische Lichtquelle (30) und eine optische Projektionsvorrichtung (31, 32, 34) zur Projektion der Strahlung in Form eines parallelen Bündels auf eine Maske umfaßt, wobei auf die Maske ein Markierungsmotiv (4) aufgezeichnet ist, das wenigstens eine Fresnelzonenlinse mit linienförmigen Zonen in Form von lichtundurchlässigen und lichtdurchlässigen Zonen bildet, und wobei eine mittlere reflektierende, zu den Linsenzonen parallele Zone auf die mit der Maske (1) auszurichtende Probe (2) aufgezeichnet ist, wobei Verschiebungsmittel (21) zum Verschieben der Probe in bezug auf die Maske entlang einer zu der aufgezeichneten zentralen Zone senkrechten Achse vorgesehen sind, um den durch das Bündel erster Ordnung, das von der Fresnel-Linse gebeugt wird, gebildeten Lichtstreifen mit der mittleren Zone des auf die Probe aufgezeichneten Motivs in Koinzidenz zu bringen, und wobei die Vorrichtung ferner einen Detektor (37) umfaßt, welcher die von der Probe reflektierte Strahlung erfaßt, wobei die Koinzidenz einem Signalextremwert entspricht.

9. Ausrichtvorrichtung nach Anspruch 8, dadurch gekennzeichnet, daß die mittlere Zone des auf die Maske aufgezeichneten Motivs ein Reflexionsgitter konstanter Teilung bildet, wobei die von diesem Gitter empfangene Strahlung in der Ebene gebeugt wird, die durch die optische Achse des einfallenden Bündels und das Gitter gebildet ist, und wobei der Detektor sich in der Achse des Bündels befindet, die einer der Beugungsordnungen entspricht und in bezug auf die Achse der einfallenden Strahlung geneigt ist.

10. Ausrichtvorrichtung nach Anspruch 9, dadurch gekennzeichnet, daß der Detektor entlang der optischen Achse des von dem Reflexionsgitter konstanter Teilung gebeugten Bündels erster Ordnung angeordnet ist.

11. Ausrichtvorrichtung nach einem der Ansprüche 8 bis 10, dadurch gekennzeichnet, daß sie eine Vorrichtung zur Ablenkung des auf die Maske einfallenden Bündels umfaßt, die durch ein Ablenksteuersignal gesteuert ist, wobei die optische Projektionsvorrichtung eine afokale derartige Vorrichtung ist, daß das parallele Bündel die Maske in der Linsenzone mit variablem Einfall beleuchtet, wobei der projizierte Lichtstreifen über die Probe abgelenkt wird, wobei dann der Detektor ein Signal veränderlicher Amplitude liefert, das an einen Synchrondemodulator angelegt wird, an den ein mit dem Ablenksteuersignal synchrones Signal angelegt wird, und wobei der Ausgang des Demodulators ein Fehlersignal liefert, das zur Steuerung der Relativverschiebung zwischen Maske und Probe verwendet wird.

12. Ausrichtvorrichtung nach einem der Ansprüche 8 bis 11, dadurch gekennzeichnet, daß das auf die Maske aufgezeichnete Markierungsmotiv aus mehreren Fresnelzonenlinsen aus parallelen linienfömigen Zonen gebildet ist und das auf die Probe zur Ausrichtung aufgezeichnet Motiv zentrale, parallele, diesen Linsen zugeordnete Zonen umfaßt.

13. Ausrichtvorrichtung nach einem der Ansprüche 8 bis 12, dadurch gekennzeichnet, daß sie Mittel zur Verschiebung der Probe in bezug auf die Maske entlang zwei zueinander senkrechten Achsen und mit einer Drehbewegung umfaßt, wobei die Maske drei Markierungsmotive aufweist, wovon zwei Markierungsmotive jeweils wenigstens eine Fresnelzonenlinse mit linienförmigen Zonen, die senkrecht zu einer der Ausrichtachsen sind, aufweist und das dritte Markierungsmotiv wenigstens eine Fresnelzonenlinse mit linienförmigen Zonen, die senkrecht zu der anderen Ausrichtachse sind, umfaßt, wobei die den Linsen zugeordneten Markierungsmotive auf die Probe aufgezeichnet sind, wobei die optische Projektionsvorrichtung die Strahlung auf jede der Markierungen gemäß einer bestimmten Verfahrensweise projiziert und wobei ein Detektor zur Erfassung der von der Maske nach Reflexion an der Probe ausgehenden Strahlung für jede Ausrichtrichtung vorgesehen ist.

## Claims

1. Method of optically aligning patterns in two neighbouring planes using pattern markings marked on the two planes to be aligned, characterized in that it uses a pattern marking marked on the first plane and formed of at least one Fresnel zone lens of linear zones which are alternatively opaque and transparent and perpendicular to the alignment axis in the plane, and a reflecting pattern marking marked on the second plane, comprising a central zone perpendicular to the alignment axis, the alignment method consisting of illuminating the linear Fresnel zone lens by a parallel monochromatic light beam in a manner to form within the second plane a light track having substantially the same dimensions as the central zone of the pattern marked on that plane, detecting the radiation reflected by this second plane, and emerging from the linear Fresnel zone lens, and displacing the two planes one with respect to the other until the detected radiation passes through an extremum corresponding to the alignment of the two markings.

2. Alignment method of claim 1, characterized in that the pattern marking marked on the second plane comprises a central zone having a reflection coefficient different from the surrounding zone.

3. Alignment method of claim 1, characterized in that the central zone of the pattern marking marked on the second plane is formed of elements having different reflection coefficients and extending in a direction perpendicular to the alignment direction for forming a reflection amplitude grid of constant pitch in this direction.

4. Alignment method of claim 1, characterized in that the central zone of the pattern marking marked on the second plane is engraved for forming a reflection phase grid of constant pitch extending in a direction perpendicular to the alignment direction.

5. Alignment method of any of claims 1 to 4, characterized in that, for an automatic alignment, the angle of incidence of the beam on the linear Fresnel zone lens is alternatively deflected on both sides of a medium position, the automatic alignment being obtained by controlling the relative displacement of the two planes by the output signal of a synchronous demodulator receiving a signal characteristic of the back-radiation reflected by the second plane and a signal synchronous with the deflection control signal of the beam incident on said lens.

6. Alignment method of any of claims 2 to 5, characterized in that the pattern marking marked on the second plane comprises, in addition to the central zone, lateral zones extending in the alignment direction and allowing an approximation of the central zone prior to precise alignment.

7. Alignment method of any of the preceding claims, characterized in that the alignment marking marked on the first plane comprises a plurality of Fresnel zone lenses of linear parallel zones, the corresponding pattern marked on the second plane comprising a plurality of central zones respectively associated with these lenses.

8. Device for performing the method of claim 1, characterized in that it comprises a monochromatic light source (30) and an optical projection device (31, 32, 34) for projecting radiation in a parallel beam onto a mask, a pattern marking (4) forming at least one linear Fresnel zone lens being marked on the mask forming opaque and transparent zones and a central reflecting zone parallel to the lens zones being marked on the sample (2) to be aligned with the mask (1), displacement means (21) for displacing the sample with respect to the mask along an axis normal to the marked central zone being provided for bringing the light track formed by the first order beam diffraction by the linear Fresnel zone lens into coincidence with the central zone of the pattern marked on the sample, the device further comprising a detector (37) detecting the radiation reflected by the sample, the coincidence corresponding to a signal extremum.

9. Alignment device of claim 8, characterized in that the central zone of the pattern marked on the mask forms a constant pitch reflecting grid, the radiation received by this grid being diffracted in the plane formed by the optical axis of the incident beam and the grid, the detector being arranged in the axis of the beam corresponding to one of the diffraction orders and inclined with respect to the incident radiation axis.

10. Alignment device of claim 9, characterized in that the detector is arranged along the optical axis of the first order diffracted beam of the constant pitch reflecting grid.

11. Alignment device of any of claims 8 to 10, characterized in that it comprises a device for deflecting the beam incident on the mask controlled by a deflection control signal, the optical projection device being a device without focus of such kind that the parallel beam illuminates the mask in the lens zone with variable incidence, the projected light track scanning the sample, whereby the detector supplies a variable amplitude signal applied to a synchronous demodulator to which a signal synchronous with the deflection control signal is applied, the output of the demodulator supplying an error signal used for controlling the relative displacement of the mask and the sample.

12. Alignment device of any of claims 8 to 11, characterized in that the pattern marking marked on the mask is formed of a plurality of parallel linear Fresnel zone lenses, the alignment pattern marked on the sample including parallel central zones associated with these lenses.

13. Alignment device of any of claims 8 to 12, characterized in that it comprises means for displacing the sample with respect to the mask along two perpendicular axes and by rotation, the mark comprising three pattern markings, two of the pattern markings each comprising at least one Fresnel lens of linear zones perpendicular to one of the alignment axes and the third pattern marking comprising at least one Fresnel lens of linear zones perpendicular to the other alignment axis, the pattern markings associated with the lenses being marked on the sample, the optical projection device projecting the radiation onto each of the markings in accordance with a determined procedure, a detector for detecting radiation emerging from the mask after reflexion on the sample being provided for each alignment direction.

FIG. 1

FIG. 2

FIG. 3

Fig.4

Fig.5

Fig.6

0 010 998

FIG. 7

FIG. 8

3

0 010 998

4 - 5

FIG. 9

# FIG. 10 a)

# FIG. 10 b)

# FIG. 11

5

0 010 998

FIG. 12